# EUROPÄISCHE PATENTSCHRIFT

(11) **EP 0 984 553 B1**
(45) Veröffentlichungstag und Bekanntmachung des Hinweises auf die Patenterteilung: **21.05.2003**
(21) Anmeldenummer: 99105896.7
(22) Anmeldetag: 24.03.1999
(51) Int. Cl.: H03D 9/06

(54) **Doppelgegentaktmischer**
Double balanced mixer
Mélangeur équilibré double

(30) Priorität: 02.09.1998 DE 19839890
(43) Veröffentlichungstag der Anmeldung: 08.03.2000
(73) Patentinhaber: ROBERT BOSCH GMBH, 70442 Stuttgart (DE)
(72) Erfinder: Gill, Hardial, 71522 Backnang (DE)
(74) Vertreter: Manitz, Finsterwald & Partner

(56) Entgegenhaltungen:
- US-A- 5 774 801
- BRINLEE W R ET AL: "A NOVEL PLANAR DOUBLE-BALANCED 6-18 GHZ MMIC MIXER" IEEE MTT-S INTERNATIONAL MICROWAVE SYMPOSIUM DIGEST,US,NEW YORK, IEEE, Seite 9-12 XP000527234 ISBN: 0-7803-1779-3
- MAAS S: "A BROADBAND PLANAR MONOLITHIC RING MIXER" IEEE MICROWAVE AND MILLIMETER-WAVE MONOLITHIC CIRCUITS SYMPOSIUM. MMWMC,US,NEW YORK, IEEE, Seite 51-54 XP000683193 ISBN: 0-7803-3361-6

## Beschreibung

### Stand der Technik

Die vorliegende Erfindung betrifft einen Doppelgegentaktmischer, bestehend aus einem Diodenring, der mit jeweils einem Symmetrierglied für ein Lokaloszillatorsignal und für ein Hochfrequenzsignal und mit einer kapazitiv belasteten Leitungsverzweigung für ein Zwischenfrequenzsignal beschaltet ist.

Ein derartiger Doppelgegentaktmischer ist aus einer Veröffentlichung von W. Brinlee, K. Varian, M. Pavio, "A Novel Planar Double-Balanced 6-8 GHz MMIC Mixer", IEEE MTT-Symposium Digest, 1994, Session TV1A-2 bekannt. Der Diodenring dieses Doppelgegentaktmischers besteht aus 4 Dioden, die nebeneinander angeordnet sind, und deren Verbindungsleitungen in Form einer unsymmetrischen 8 geführt sind. Das Symmetrierglied für das RF-Signal und das Symmetrierglied für das Lokaloszillatorsignal bestehen jeweils aus zwei miteinander gekoppelten Leitungen, zwischen denen zur Verstärkung der Kopplung konzentrierte Kapazitäten vorgesehen sind. Durch den Einsatz konzentrierter Kapazitäten in den Symmetriergliedern erschwert sich deren Entwurf, insbesondere wenn bei sehr hohen Frequenzen (30 Ghz) exakte elektrische Eigenschaften erzielt werden sollen. Die Leitungsverzweigung für das Zwischenfrequenzsignal ist rein kapazitiv belastet, wodurch eventuell störende Resonanzen entstehen können.

Der Erfindung liegt die Aufgabe zugrunde, einen Doppelgegentaktmischer der eingangs genannten Art anzugeben, bei dem die Eingänge für das Lokaloszillatorsignal und für das RF-Signal möglichst gut gegeneinander entkoppelt sind und der möglichst geringe Konversionsverluste aufweist.

### Vorteile der Erfindung

Die genannte Aufgabe wird mit den Merkmalen des Anspruchs 1 dadurch gelöst, daß jedes der beiden Symmetrierglieder für das Lokaloszillatorsignal und für das Hochfrequenzsignal einen ersten aus zwei Streifenleitungen bestehenden Koppler und einen zweiten als Interdigitalkoppler ausgeführten zweiten Koppler aufweist. Der erste Koppler ist an einem ersten symmetrischen Eingang und der zweite Koppler an einem zweiten symmetrischen Eingang des Diodenrings angeschlossen, und beide Koppler sind an einem ihrer Tore miteinander verbunden, und zwei Tore des ersten Kopplers bilden einen unsymmetrischen Eingang für das Lokaloszillatorsignal bzw. für das Hochfrequenzsignal. Ein solches nur aus planaren Leitungen bestehendes Symmetrierglied läßt sich relativ einfach unter Berücksichtigung exakt einzuhaltender elektrischer Eigenschaften entwerfen. Auch sind die beiden aus jeweils zwei Koppelstrukturen zusammengesetzten Symmetrierglieder geeignet, eine hohe Isolation zwischen dem Lokaloszillatorsignal und dem Hochfrequenzsignal zu erzielen.

Gemäß Unteransprüchen besteht der Interdigitalkoppler aus mindestens vier nebeneinander verlaufenden Streifenleitungen, von denen je zwei nicht benachbarte Streifenleitungen an einem Ende miteinander verbunden sind. Dabei ist das Symmetrierglied vorzugsweise so aufgebaut, daß ein erstes Tor des ersten Kopplers mit einem ersten symmetrischen Eingang des Diodenrings verbunden ist, ein zweites Tor an Masse liegt, ein drittes Tor einen Eingang für das Lokaloszillator- bzw. Hochfrequenzsignal bildet und ein viertes Tor mit dem zweiten Koppler verbunden ist, und daß ein erstes Tor des zweiten Kopplers mit einem zweiten symmetrischen Eingang des Diodenrings verbunden ist, ein zweites Tor an Masse liegt, ein drittes Tor leerlaufend ist und ein viertes Tor mit dem vierten Tor des ersten Kopplers verbunden ist.

Vorzugsweise sind zwischen den symmetrischen Eingängen des Diodenrings für das Lokaloszillatorsignal und den Anschlußtoren des Symmetriergliedes induktiv wirkende Leitungsstücke und eine beide Eingänge überbrückende Kapazität eingefügt. Außerdem sind zwischen den symmetrischen Eingängen des Diodenringes für das Hochfrequenzsignal und den Anschlußtoren des Symmetriergliedes Kapazitäten eingefügt.

Der Diodenring besteht vorteilhafterweise aus vier Dioden, die nebeneinander liegen, wobei die Verbindungsleitungen zwischen ihnen die Form einer unsymmetrischen 8 haben und die Verbindungsleitungen so dimensioniert sind, daß die Dioden gegenseitig angepaßt sind. Es handelt sich hierbei um einen sehr platzsparenden Diodenring, der außerdem eine gute Trennung zwischen dem Lokaloszillatorsignal und dem Hochfrequenzsignal gewährleistet.

Die Leitungsverzweigung für den Zwischenfrequenzsignalanschluß besteht vorzugsweise aus zwei λ/4 langen gekoppelten Leitungen, die mit den Anschlüssen für das Hochfrequenzsignal am Diodenring verbunden sind, wobei jede der beiden Leitungen über ein RC-Glied mit Masse verbunden ist. Dadurch werden unerwünschte Resonanzen weitgehend unterdrückt.

### Beschreibung eines Ausführungsbeispiels

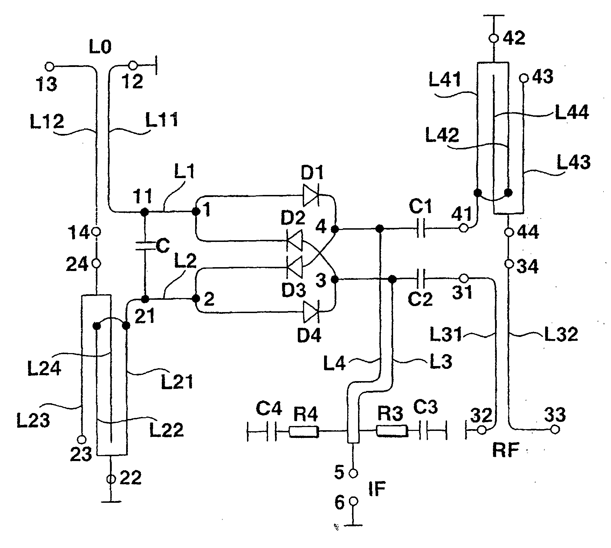

Anhand eines in der Zeichnung dargestellten Ausführungsbeispiels wird nachfolgend die Erfindung näher erläutert.

Die einzige Figur der Zeichnung zeigt einen planaren monolithischen Doppelgegentaktmischer, bei dem die planaren Leitungen als einfache Linien dargestellt sind. Natürlich haben die Leitungen in der Realität eine ganz bestimmte Breite und Länge, die von der gewünschten Übertragungscharakteristik abhängen. Auf die exakte Dimensionierung aller Leitungen soll hier aber nicht näher eingegangen werden, da sie aus für den Fachmann bekannten Entwurfsmethoden hervorgehen.

Der Doppelgegentaktmischer enthält einen Diodenring, der hier beispielsweise aus vier Dioden D1, D2, D3 und D4 besteht. Um einen platzsparenden Aufbau des Diodenrings zu erzielen, sind die Verbindungsleitungen zwischen den einzelnen Dioden D1, D2, D3 und D4 so verlegt, daß sich eine unsymmetrische 8 ergibt. Die Leitungen zwischen den Dioden D1, D2, D3, D4 und den symmetrischen Eingängen 1, 2, 3, 4 sind so dimensioniert, daß eine gegenseitige Anpassung zwischen den Dioden gegeben ist und eine optimale Entkopplung zwischen dem an den Eingängen 1 und 2 anliegenden Lokaloszillatorsignal LO und dem an den symmetrischen Eingängen 3 und 4 anliegenden Hochfrequenzsignal RF.

Da die Eingänge 1, 2 und 3, 4 des Diodenringes symmetrisch sind, das Lokaloszillatorsignal LO und das Hochfrequenzsignal RF aber an unsymmetrischen Toren 12, 13, und 32, 33 anliegen, werden das Lokaloszillatorsignal LO und das Hochfrequenzsignal RF über Symmetrierglieder dem Diodenring zugeführt. Das Symmetrierglied für das Lokaloszillatorsignal LO besteht aus einem ersten aus zwei Leitungen L11 und L12 gebildeten Koppler und einem damit verbundenen zweiten als Interdigitalkoppler ausgebildeten Koppler. Der Interdigitalkoppler besteht hier aus vier nebeneinanderliegenden Leitungen L21, L22, L23, L24, von denen jeweils zwei nicht benachbarte Leitungen L21, L22 an einem Ende und die anderen beiden nicht benachbarten Leitungen L21, L22 an beiden Enden miteinander verbunden sind. Diese Form eines Interdigitalkopplers wird in der Fachwelt auch als "Lange-Koppler" bezeichnet.

Mit einem ersten Tor 11 an der Leitung L11 ist der erste Koppler an den ersten symmetrischen Eingang 1 des Diodenrings angeschlossen. Das zweite Tor 12 an der Leitung L11 ist an Masse gelegt. Zwischen dem dritten Tor 13 an der zweiten Leitung L12 des ersten Kopplers und dem zweiten Tor 12 liegt das Lokaloszillatorsignal LO an. Das vierte Tor 14 an der zweiten Leitung L12 des ersten Kopplers ist mit dem Tor 24 des zweiten Kopplers verbunden.

Ein erstes Tor 21 der ersten Leitung L21 des zweiten Kopplers ist an den zweiten symmetrischen Eingang 2 des Diodenrings angeschlossen. Das zweite Tor 22 des zweiten Kopplers, an dem die erste Leitung L21 und die zweite Leitung L22 miteinander verbunden sind, liegt an Masse. Das dritte Tor 23 an der dritten Leitung L23 ist leerlaufend, ebenso ist das Ende der mit der dritten Leitung L23 verbundenen vierten Leitung L24 leerlaufend, und die Verbindung zwischen den beiden Leitungen L23 und L24 bildet das vierte Tor 24, das mit dem vierten Tor 14 des ersten Kopplers verbunden ist. Die miteinander gekoppelten Leitungen L11 und L12 des ersten Kopplers und L21, L22, L23, L24 haben eine Länge von λ/4 der Wellenlänge des Lokaloszillatorsignals LO.

Zwischen den Toren L11 und L21 des Symmetriergliedes und den symmetrischen Eingängen 1 und 2 des Diodenrings sind Leitungsabschnitte L1 und L2 eingefügt, und außerdem sind die beiden Tore 11 und 21 mit einer Kapazität C überbrückt. Die induktiv wirkenden Leitungsabschnitte L1, L2 und die Kapazität C bewirken eine gute Anpassung des Symmetriergliedes an die Tore 1 und 2 des Diodenringes.

Das Symmetrierglied für das Hochfrequenzsignal RF ist ähnlich aufgebaut wie das Symmetrierglied für das Lokaloszillatorsignal LO. Ein erster Koppler, bestehend aus den zwei Leitungen L31 und L32, ist mit seinem ersten Tor 31 an den symmetrischen Eingang 3 des Diodenrings angeschlossen und mit seinem Tor 32 an Masse gelegt. Zwischen dem dritten Tor 33 und dem zweiten Tor 32 des ersten Kopplers liegt das Hochfrequenzsignal RF an. Das vierte Tor 34 des ersten Kopplers ist mit dem vierten Tor 44 des als Interdigitalkoppler ausgeführten zweiten Kopplers verbunden. Der Interdigitalkoppler besteht aus vier nebeneinander verlaufenden Leitungen L41, L42, L43 und L44, wobei zwei nicht nebeneinanderliegende Leitungen L41, L42 an einem Ende und die anderen beiden nicht benachbarten Leitungen L43 und L44 an beiden Enden miteinander verbunden sind. Das erste Tor 41 an der Leitung 41 ist an den symmetrischen Eingang 4 des Diodenrings angeschlossen. Die mit der Leitung L41 verbundene Leitung L42 ist an ihrem freien Ende leerlaufend. Der Verzweigungspunkt der beiden Leitungen L41 und L42 bildet das zweite Tor 42, das an Masse liegt. Von den anderen beiden miteinander verbundenen Leitungen L43 und L44 ist das dritte Tor 43 an der Leitung L43 leerlaufend. Ebenso ist das freie Ende der Leitung L44 leerlaufend. Am Verzweigungspunkt der beiden Leitungen L43 und L44 befindet sich das vierte Tor 44, das mit dem vierten Tor 34 des ersten Kopplers verbunden ist. Die miteinander gekoppelten Leitungen L31 und L32 des ersten Kopplers und die Leitungen L41, L42, L43 und L44 des zweiten Kopplers sind jeweils λ/4 lang, wobei λ die mittlere Wellenlänge des Hochfrequenzsignals RF ist.

Zwischen dem Tor 41 und dem Eingang 4 des Diodenrings und dem Tor 31 und dem Eingang 3 des Diodenrings ist jeweils eine Kapazität C1, C2 eingefügt. Die beiden Kapazitäten C1 und C2 stellen einen Bandpass für das Hochfrequenzsignal RF und das Lokaloszillatorsignal LO dar und sperren die Zwischenfrequenz ZF. Außerdem bilden sie eine Gleichstromsperre, falls der Diodenring mit einer externen Gleichspannungsversorgung versehen sein sollte.

Das Zwischenfrequenzsignal IF wird an den symmetrischen Eingängen 3 und 4 des Diodenrings über eine Leitungsverzweigung abgeführt. Die Leitungsverzweigung besteht aus zwei miteinander gekoppelten λ/4 (λ entspricht der Zwischenfrequenz) langen Leitungen L3 und L4, die zwischen den Toren 3 und 4 und den Kapazitäten C1 und C2 angeschlossen sind. Im Bereich der Verzweigungsstelle ist jede Leitung L3, L4 über ein RC-Glied R3, C3 und R4, C4 an Masse gelegt. Mit dem Masseanschluß der Leitungen L3 und L4 über die Serienschaltung aus einem Widerstand R3, R4 und einer Kapazität C3, C4 werden Störresonanzen unterdrückt.

Der beschriebene Doppelgegentaktmischer kann sowohl als Abwärtsmischer als auch als Aufwärtsmischer betrieben werden. Als Abwärtsmischer wird neben dem Lokaloszillatorsignal LO das Hochfrequenzsignal RF zugeführt und das Zwischenfrequenzsignal abgeführt, und als Aufwärtsmischer wird neben dem Lokaloszillatorsignal LO das Zwischenfrequenzsignal IF zu und das Hochfrequenzsignal RF abgeführt.

## Patentansprüche

1. Doppelgegentaktmischer, bestehend aus einem Diodenring, der mit jeweils einem Symmetrierglied für ein Lokaloszillatorsignal und für ein Hochfrequenzsignal und mit einer kapazitiv belasteten Leitungsverzweigung für ein Zwischenfrequenzsignal beschaltet ist, **dadurch gekennzeichnet, daß** jedes der beiden Symmetrierglieder einen ersten aus zwei Streifenleitungen (L11, L12; L13, L32) bestehenden Koppler und einen zweiten als Interdigitalkoppler (L21, L22, L23, L24; L41, L42, L43, L44) ausgeführten zweiten Koppler aufweist, daß der erste Koppler (L11, L12; L31, L32) an einen ersten symmetrischen Eingang (1; 3) und der zweite Koppler (L21, L22, L23, L24; L41, L42, L43, L44) an einen zweiten symmetrischen Eingang (2; 4) des Diodenringes (D1, D2, D3, D4) angeschlossen ist, daß beide Koppler an einem ihrer Tore (14, 24; 34, 44) miteinander verbunden sind und daß zwei Tore (12, 13; 32, 33) des ersten Kopplers (L11, L12; L31, L32) einen unsymmetrischen Signaleingang bilden.

2. Doppelgegentaktmischer nach Anspruch 1, **dadurch gekennzeichnet, daß** der Interdigitalkoppler aus mindestens vier nebeneinander verlaufenden Streifenleitungen (L21, L22, L23, L24; L41, L42, L43, L44) besteht, von denen je zwei nicht benachbarte Streifenleitungen (L21, L22; L23, L24; L41, L42; L43, L44) an mindestens einem Ende miteinander verbunden sind.

3. Doppelgegentaktmischer nach Anspruch 1, **dadurch gekennzeichnet, daß** ein erstes Tor (11; 31) des ersten Kopplers mit einem ersten symmetrischen Eingang (1; 3) des Diodenrings (D1, D2, D3, D4) verbunden ist, ein zweites Tor (12; 32) an Masse liegt, ein drittes Tor (13; 33) einen Eingang für das Lokaloszillator- (LO) bzw. Hochfrequenzsignal (RF) bildet und ein viertes Tor (14; 34) mit dem zweiten Koppler verbunden ist, daß ein erstes Tor (21; 41) des zweiten Kopplers mit einem zweiten symmetrischen Eingang (2; 4) des Diodenringes (D1, D2, D3, D4) verbunden ist, ein zweites Tor (22; 42) an Masse liegt, ein drittes Tor (23; 43) leerlaufend ist und ein viertes Tor (24; 44) mit dem vierten Tor (14; 34) des ersten Kopplers verbunden ist.

4. Doppelgegentaktmischer nach Anspruch 1 oder 3, **dadurch gekennzeichnet, daß** zwischen den symmetrischen Eingängen (1, 2) des Diodenringes (D1, D2, D3, D4) für das Lokaloszillatorsignal (LO) und den Anschlußtoren (11, 21) des Symmetriergliedes induktiv wirkende Leitungsstücke (L1, L2) und eine beide Eingänge (1, 2) überbrückende Kapazität (C) eingefügt sind.

5. Doppelgegentaktmischer nach Anspruch 1 oder 3, **dadurch gekennzeichnet, daß** zwischen den symmetrischen Eingängen (3, 4) des Diodenringes (D1, D2, D3, D4) für das Hochfrequenzsignal (RF) und den Anschlußtoren (31, 41) des Symmetriergliedes Kapazitäten (C1, C2) eingefügt sind.

6. Doppelgegentaktmischer nach Anspruch 1, **dadurch gekennzeichnet, daß** der Diodenring aus vier Dioden (D1, D2, D3, D4) besteht, die nebeneinander liegen, wobei die Verbindungsleitungen zwischen ihnen die Form einer unsymmetrischen 8 haben, und daß die Verbindungsleitungen so dimensioniert sind, daß die Dioden (D1, D2, D3, D4) gegenseitig angepaßt sind.

7. Doppelgegentaktmischer nach Anspruch 1, **dadurch gekennzeichnet, daß** die Leitungsverzweigung für den Zwischenfrequenzsignalanschluß (IF) aus zwei λ/4 langen gekoppelten Leitungen (L3, L4) besteht, die mit den Anschlüssen (3, 4) für das Hochfrequenzsignal (RF) am Diodenring (D1, D2, D3, D4) verbunden sind, und daß jede der beiden Leitungen (L3, L4) über ein RC-Glied (R3, C3, R4, C4) mit Masse verbunden ist.

## Claims

1. A double-balanced mixer comprising a diode ring which is connected to a respective balancing circuit portion for a local oscillator signal and for a radio frequency signal and to a capacitively-loaded conductor branch for an intermediate frequency signal, **characterized in that** each of the two balancing circuit portions has a first coupler consisting of two strip lines (L11, L12; L31, L32) and a second coupler designed as an interdigital coupler (L21, L22, L23, L24; L41, L42, L43, L44); **in that** the first coupler (L11, L12; L31, L32) is connected to a first symmetrical input (1; 3) of the diode ring (D1, D2, D3, D4) and the second coupler (L21, L22, L23, L24; L41, L42, L43, L44) is connected to a second symmetrical input (2; 4) of the diode ring (D1, D2, D3, D4); **in that** both couplers are connected to one another at one of their gates (14, 24; 34, 44); and **in that** two gates (12, 13; 32, 33) of the first coupler form an asymmetrical signal input.

2. A double-balanced mixer in accordance with claim 1, **characterized in that** the interdigital coupler comprises at least four strip lines (L21, L22, L23, L24; L41, L42, L43, L44) extending side-by-side, of which two non-neighboring strip lines are in each case connected to one another at at least one end.

3. A double-balanced mixer in accordance with claim 1, **characterized in that** a first gate (11; 31) of the first coupler is connected to a first symmetrical input (1; 3) of the diode ring (D1, D2, D3, D4), a second gate (12; 32) is grounded, a third gate (13; 33) forms an input for the local oscillator (LO) signal and for the radio frequency (RF) signal respectively and a fourth gate (14; 34) is connected to the second coupler; **in that** a first gate (21; 41) of the second coupler is connected to a second symmetrical input (2; 4) of the diode ring (D1, D2, D3, D4), a second gate (22; 42) is grounded, a third gate (23; 43) is unconnected and a fourth gate (24; 44) is connected to the fourth gate (14; 34) of the first coupler.

4. A double-balanced mixer in accordance with claim 1 or claim 3, **characterized in that** inductively acting conductor sections (L1, L2) and a capacitor (C) bridging both inputs (1, 2) are inserted between the symmetrical inputs (1, 2) of the diode ring (D1, D2, D3, D4) for the local oscillator signal (LO) and the connecting gates (11, 21) of the balancing circuit portion.

5. A double-balanced mixer in accordance with claim 1 or claim 3, **characterized in that** capacitors (C1, C2) are inserted between the symmetrical inputs (3, 4) of the diode ring (D1, D2, D3, D4) for the radio frequency signal (RF) and the connecting gates (31, 41) of the balancing circuit portion.

6. A double-balanced mixer in accordance with claim 1, **characterized in that** the diode ring consists of four diodes (D1, D2, D3, D4) arranged side-by-side, with the connecting lines between them having the form of an asymmetric 8; and **in that** the connecting lines are dimensioned such that the diodes (D1, D2, D3, D4) are mutually matched.

7. A double-balanced mixer in accordance with claim 1, **characterized in that** the conductor branch for the intermediate frequency signal connector (IF) consists of two coupled conductors (L3, L4) of a length of λ/4 which are connected to the connectors (3, 4) for the radio frequency signal (RF) at the diode ring (D1, D2, D3, D4); and **in that** each of the two conductors (L3, L4) are connected to ground via an RC member (R3, C3, R4, C4).

## Revendications

1. Mélangeur push-pull double constitué par une boucle de diodes qui est câblée avec un transformateur d'entrée symétrique/dissymétrique respectif pour un signal d'oscillateur local et pour un signal de haute fréquence et avec une ramification de ligne à charge capacitive pour un signal de fréquence intermédiaire, **caractérisé en ce que** chacun des deux transformateurs d'entrée symétrique/dissymétrique comprend un premier coupleur constitué par deux lignes à bande (L11, L12 ; L31, L32) et un deuxième coupleur réalisé sous forme de coupleur interdigital (L21, L22, L23, L24 ; L41, L42, L43, L44), **en ce que** le premier coupleur (L11, L12 ; L31, L32) est branché à une première entrée symétrique (1 ; 3) et le deuxième coupleur (L21, L22, L23, L24 ; L41, L42, L43, L44) est branché à une deuxième entrée symétrique (2 ; 4) de la boucle de diodes (D1, D2, D3, D4), **en ce que** les deux coupleurs sont reliés l'un à l'autre sur l'une de leurs portes (14, 24 ; 34, 44), et **en ce que** deux portes (12, 13 ; 32, 33) du premier coupleur (L11, L12 ; L31, L32) forment une entrée de signal dissymétrique.

2. Mélangeur push-pull double selon la revendication 1, **caractérisé en ce que** le coupleur interdigital est constitué par au moins quatre lignes à bande (L21, L22, L23, L24 ; L41, L42, L43, L44) s'étendant les unes à côté des autres, dont deux lignes à bande respectives non voisines (L21, L22 ; L23, L24 ; L41, L42 ; L43, L44) sont reliées l'une à l'autre à au moins une extrémité.

3. Mélangeur push-pull double selon la revendication 1, **caractérisé en ce qu'**une première porte (11 ; 31) du premier coupleur est reliée à une première entrée symétrique (1 ; 3) de la boucle de diodes (D1, D2, D3, D4), une deuxième porte (12 ; 32) est branchée à la masse, une troisième porte (13 ; 33) forme une entrée pour le signal d'oscillation local (LO) ou pour le signal de haute fréquence (RF) et une quatrième porte (14 ; 34) est reliée au deuxième coupleur, **en ce qu'**une première porte (21 ; 41) du deuxième coupleur est reliée à une deuxième entrée symétrique (2 ; 4) de la boucle de diodes (D1, D2, D3, D4), une deuxième porte (22 ; 42) est branchée à la masse, une troisième porte (23 ; 43) est à vide et une quatrième porte (24 ; 44) est reliée à la quatrième porte (14 ; 34) du premier coupleur.

4. Mélangeur push-pull double selon l'une ou l'autre des revendications 1 et 3, **caractérisé en ce que** des tronçons de ligne à action inductive (L1, L2) et un condensateur (C) pontant les deux entrées (1, 2) sont intégrés entre les entrées symétriques (1, 2) de la boucle de diodes (D1, D2, D3, D4) pour le signal d'oscillateur local (LO) et les portes de connexion (11, 21) du transformateur d'entrée symétrique/ dissymétrique.

5. Mélangeur push-pull double selon l'une ou l'autre des revendications 1 et 3, **caractérisé en ce que** des condensateurs (Cl, C2) sont intégrés entre les entrées symétriques (3, 4) de la boucle de diodes (D1, D2, D3, D4) pour le signal de haute fréquence (RF) et les portes de connexion (31, 41) du transformateur d'entrée symétrique/dissymétrique.

6. Mélangeur push-pull double selon la revendication 1, **caractérisé en ce que** la boucle de diodes est constituée par quatre diodes (D1, D2, D3, D4) qui se trouvent les unes à côté des autres, les lignes de liaison entre elles présentant la forme d'un 8 dissymétrique, et **en ce que** les lignes de liaison sont dimensionnées telles que les diodes (D1, D2, D3, D4) sont adaptées mutuellement.

7. Mélangeur push-pull double selon la revendication 1, **caractérisé en ce que** la ramification de lignes pour le raccord de signal de fréquence intermédiaire (IF) est constituée par deux lignes couplées (L3, L4) d'une longueur de λ/4 qui sont reliées aux raccords (3, 4) pour le signal de haute fréquence (RF) sur la boucle de diodes (D1, D2, D3, D4), et **en ce que** chacune des deux lignes (L3, L4) est reliée à la masse via un circuit RC (R3, C3, R4, C4).
